# EUROPEAN PATENT APPLICATION

(11) **EP 1 128 434 A2**
(43) Date of publication of application: **29.08.2001**
(21) Application number: 00123414.5
(22) Date of filing: 02.11.2000
(51) Int. Cl.: H01L 23/538, H01L 23/66

(54) **Multi-layered multi-chip module for high frequencies**

(30) Priority: 23.02.2000 KR 0008822
(71) Applicant: Telephus Inc., Seoul (KR)
(72) Inventor: Kwon, Young-Se, Daejeon-city (KR)
(74) Representative: Modiano, Guido, Dr.-Ing.

(57) **Abstract**

Disclosed is a multi-layered multi-chip module which comprises a substrate, a first electric shield line formed on the substrate, a passive element layer having passive elements and being formed on the first electric shield line, a second electric shield line formed on the passive element layer, an interconnection layer having a connection line electrically connected to the passive elements and being formed on the second electric shield line, a third electric shield line formed on the interconnection layer, a plurality of bumpers electrically connected to the connection line and formed on the outside of the third electric shield line, and a plurality of integrated circuits (IC) or electrical elements formed on the bumper. According to the present invention, the base band unit and the RF unit can be formed into a single module, and the size of the module can be reduced since the ICs and the passive elements are provided in the different layers.

## Description

### BACKGROUND OF THE INVENTION

### (a) Field of the Invention

The present invention relates to a multi-chip module (MCM). More specifically, the present invention relates to a multi-layered MCM including elements for processing frequencies of a radio frequency (RF) band and elements for processing base band signals.

### (b) Description of the Related Art

A mobile communication terminal comprises an RF unit for processing RF band frequencies, an intermediate frequency (IF) band unit for converting RF signals into base band signals or converting the base band signals into RF signals, and a processor for processing the base band signals, such as Qualcomm's MSM. As sizes of mobile communication terminals have recently become smaller, terminal manufacturers have made a plurality of communication components into a single module to reduce the size of the terminals.

However, base band units and RF units are conventionally formed into separate modules, and therefore the amount of size reduction the terminals can undergo is restricted.

### SUMMARY OF THE INVENTION

It is an object of the present invention to provide a multi-layered MCM for integrating a base band unit and an RF unit into a single module.

In one aspect of the present invention, a multi-layered multi-chip module comprises: a substrate; a first electric shield line formed on the substrate; a passive element layer having passive elements and being formed on the first electric shield line; a second electric shield line formed on the passive element layer; an interconnection layer having a connection line electrically connected to the passive elements and being formed on the second electric shield line; a third electric shield line formed on the interconnection layer; a plurality of bumpers electrically connected to the connection line and formed on the outside of the third electric shield line; and a plurality of integrated circuits (IC) or electrical elements formed on the bumper.

The third electric shield line has an open area, and the connection line is electrically connected to the bumper via the open area.

The second electric shield line has an open area, and the connection line is connected to the passive element via the open area,

The ICs comprise one or more first ICs for processing RF band signals, and one or more second ICs for processing the base band signals.

### BRIEF DESCRIPTION OF THE DRAWINGS

The accompanying drawings, which are incorporated in and constitute a part of the specification, illustrate an embodiment of the invention, and, together with the description, serve to explain the principles of the invention:
FIG. 1 shows a structure of a multi-layered multi-chip module according to a preferred embodiment of the present invention;
FIGs. 2(a) and 2(b) show a connection state between a bumper and a connection line according to the preferred embodiment of the present invention;
FIG. 3 shows a connection state between the connection line and a passive element according to the preferred embodiment of the present invention;
FIG. 4 shows a cross-sectional view of FIG. 3 cut with a line C-C';
FIGs. 5(a) and 5(b) show an inductor according to the preferred embodiment of the present invention;
FIG. 6 shows a capacitor according to the preferred embodiment of the present invention; and
FIG. 7 shows a capacitor according to a second preferred embodiment of the present invention.

### DETAILED DESCRIPTION OF THE PREFERRED EMBODIMENTS

In the following detailed description, only the preferred embodiment of the invention has been shown and described, simply by way of illustration of the best mode contemplated by the inventor(s) of carrying out the invention. As will be realized, the invention is capable of modification in various obvious respects, all without departing from the invention. Accordingly, the drawings and description are to be regarded as illustrative in nature, and not restrictive.

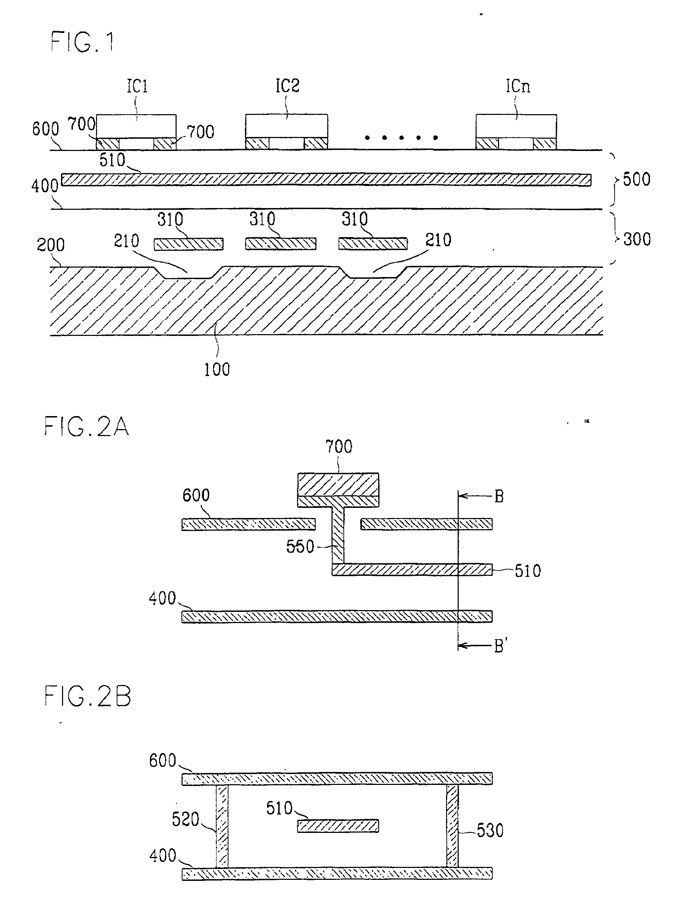

FIG. 1 shows a structure of a multi-layered multi-chip module according to a preferred embodiment of the present invention.

As shown, the multi-layered multi-chip module comprises a semiconductor substrate 100, a first electric shield line 200, a passive element layer 300, a second electric shield line 400, an interconnection layer 500, a third electric shield line 600, a bumper 700, and a plurality of integrated circuits IC1, IC2, ..., ICn or electric elements (not illustrated).

The semiconductor substrate 100 has grooves 210 each having a flat bottom, and the first electric shield line 200 is formed on the surface of the semiconductor substrate 100 and the grooves.

Passive elements 310 such as resistors, inductors and capacitors are provided in the passive element layer 300 provided between the first and second electric shield lines 200 and 400. Here, the passive elements 310 are supported by supporters (not illustrated) on the first electric shield line 200.

The second electric shield line 400 is provided on the passive element layer 300, and is supported by a supporter (not illustrated). Here, the first and second electric shield lines 200 and 400 electrically shield the passive elements 310.

The electric shield lines in the preferred embodiment of the present invention include a ground, a bias voltage supplying line, or a mixed line of the ground and the bias voltage supplying line. The electric shield line shields passing states of electrical signals.

A first connection line 510 for connection between the passive elements 310 and between the passive elements and integrated circuits in another layer is provided in the interconnection layer 500 provided between the second and third electric shield lines 400 and 600. At this time, a supporter (not illustrated) supports the first connection line 510.

The third electric shield line 600 is provided on the interconnection layer 500 and is supported by a supporter (not illustrated). The first connection line 510 is electrically shielded by the second and third electric shield lines 400 and 600.

The bumper 700 is electrically connected to the first connection line 510 and the integrated circuits (IC).

The integrated circuits IC1, IC2, ..., and ICn are electrically connected to the first connection line 510 via the bumper 700. In the preferred embodiment, the integrated circuits include RF ICs (e.g., MMIC), base band processing ICs, field effect transistors (FET) and bipolar junction transistors (BJT).

Referring to FIGs. 2(a) and 2(b), connection states between the bumper 700 and the first connection line 510 will now be described.

As shown in FIG. 2(a), a supporter 550 is provided on the first connection line 510, and the supporter 550 is protruded to the outside of the third electric shield line 600 through an open area of the third electric shield line 600. The bumper 700 is provided on the supporter 550, and is electrically connected to the first connection line 510 via the supporter 550.

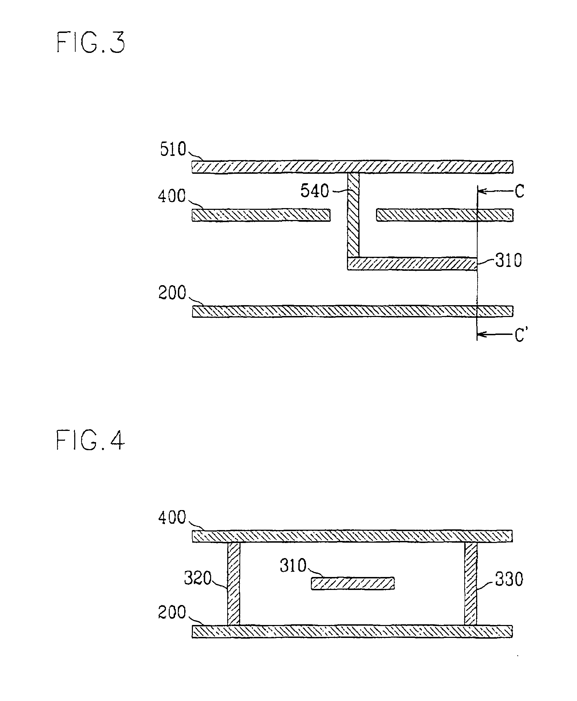

FIG. 2(b) shows a cross-sectional view of FIG. 2(a) cut with respect to the line B-B'. As shown, since the first connection line 510 is surrounded by the second and third electric shield lines 400 and 600 and is electrically shielded, signal interference between the first connection line 510 and outer ICs or between the first connection line 510 and the passive elements 310 can be reduced. If needed, additional electric shield lines 520 and 530 can be provided to electrically shield the first connection line 510. At this time, if a plurality of connection lines is necessary, multi-layered connection lines can be manufactured. In this case, the connection line each provided in a different layer can be connected via a second connection line 540 as shown in FIG. 3.

Referring to FIG. 3, connection states between the first connection line 510 and the passive element 310 will now be described.

As shown, the passive element 310 is connected to the second connection line 540, which is connected to the first connection line 510 via an open area of the second electric shield line 400. Accordingly, the passive element 310 is electrically connected to the integrated circuits IC1, 1C2, ..., ICn via the connection lines 510 and 540. Also, when a plurality of passive elements is necessary, the passive elements can be manufactured in a multi-layered manner, and in this case, the passive elements each provided in a different layer can be connected via the second connection line 540.

FIG. 4 shows a cross-sectional view of FIG. 3 cut with a line C-C'. As shown, since the passive element 310 is surrounded by the first and second electric shield lines 200 and 400 and is electrically shielded, signal interference between the passive element 310 and the first connection line 510 can be reduced. If needed, additional electric shield lines 320 and 330 can be provided to electrically shield other passive elements 310.

The passive elements 310 according to the preferred embodiment of the present invention will now be described.

The passive elements 310 comprise the resistors, the inductors and the capacitors.

Resistance values depend on material and physical structure of the passive elements 310, that is, width and length of the passive elements. In the preferred embodiment of the present invention, the resistance values are mainly obtained by optimizing the physical structure of the passive elements.

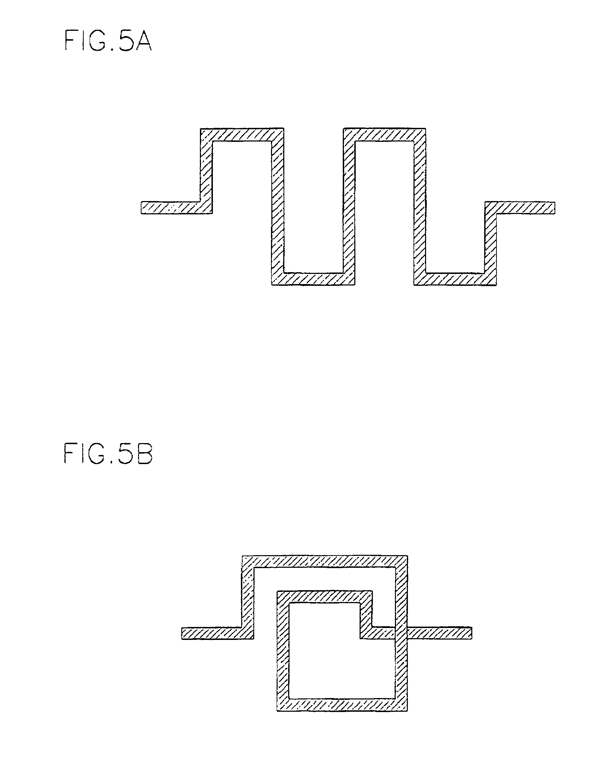

The inductors can be obtained by arranging metallic passive elements in a zigzag manner on a plane as shown in FIG, 5(a), in a spiral manner as shown in FIG. 5(b), or in other manners.

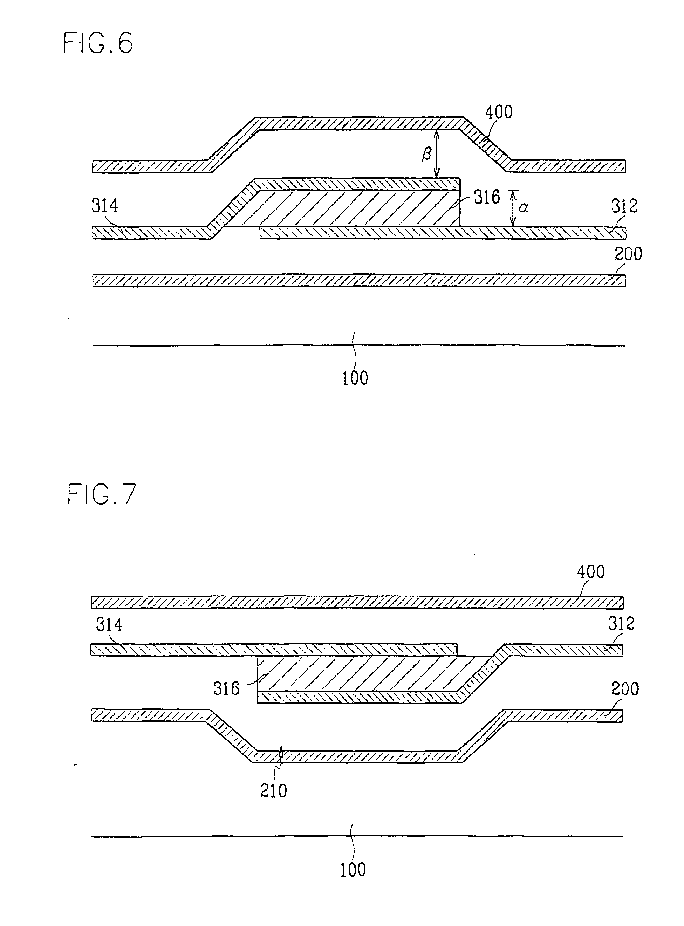

FIG. 6 shows the capacitor according to the preferred embodiment of the present invention.

As shown, the capacitor is obtained by providing first and second metal layers 312 and 314 between the first and second electric shield lines 200 and 400, and inserting a dielectric 316 into an area where the first and second metal layers 312 and 314 are superimposed.

At this time, if a length from the first metal layer 312 to the second metal layer 314 is set to be a, and a length from the second metal layer 314 to the second electric shield line 400 to be β, it is preferable to design the value of ^{β}/_{α} to be fully greater than 1. Further, it is also preferable to make the length from the first electric shield line 200 to the first metal layer 312 almost identical with the length from the second electric shield line 400 to the second metal layer 314.

When providing the capacitor on the plane part of the semiconductor substrate, the first electric shield line 200 and the first metal layer 312 are planar as shown in FIG. 6, but the second electric shield line 400 and the second metal layer 314 are bent, and thereby following processes can become difficult.

Hence, it is preferable to provide the capacitor on the groove 210 of the semiconductor substrate as shown in FIG. 7. Then, the first electric shield line 200 and the first metal layer 312 are partially bent, and the second electric shield line 400 and the second metal layer 314 become flat, and therefore, following processes can be smoothly performed. At this time, it is preferable to use the chemical mechanical polishing (CMP) process so as to make the second electric shield line 400 and the second metal layer 314 flat. It is also possible to provide the inductor on the groove 210 of the semiconductor substrate in the same manner of manufacturing the capacitor.

According to the multi-layered MCM structure of the preferred embodiment of the present invention, an IC for processing the RF signals and an IC for processing the base band signals are mounted on the bumper 700, and the passive elements such as the resistors, capacitors and inductors are mounted on a passive element layer, and the passive elements and the ICs are connected via the connection line on the interconnection layer. Therefore, the sizes of the terminals can be reduced.

Since the passive elements and the connection lines are electrically shielded, signal interference can be reduced.

In the preferred embodiment, the semiconductor substrate is used, but other types of substrates can also be used.

According to the present invention, the base band unit and the RF unit can be formed into a single module.

According to the present invention, the size of the module can be reduced since the ICs and the passive elements are provided in the different layers.

While this invention has been described in connection with what is presently considered to be the most practical and preferred embodiment, it is to be understood that the invention is not limited to the disclosed embodiments, but, on the contrary, is intended to cover various modifications and equivalent arrangements included within the spirit and scope of the appended claims.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A multi-layered multi-chip module comprising:
a substrate;
a first electric shield line formed on the substrate;
a passive element layer having passive elements and being formed on the first electric shield line;
a second electric shield line formed on the passive element layer;
an interconnection layer having a connection line electrically connected to the passive elements and being formed on the second electric shield line;
a third electric shield line formed on the interconnection layer;
a plurality of bumpers electrically connected to the connection line and formed on the outside of the third electric shield line; and
a plurality of integrated circuits (IC) or electrical elements formed on the bumper.

2. The module of claim 1, wherein the third electric shield line has an open area, and the connection line is electrically connected to the bumper via the open area.

3. The module of claim 2, wherein the module further comprises a conductive supporter, connected to the connection line, for supporting the bumper.

4. The module of claim 1, wherein the second electric shield line has an open area, and the connection line is connected to the passive element via the open area.

5. The module of claim 3, wherein the passive element is identified as one or more of a resistor, an inductor and a capacitor.

6. The module of claim 3, wherein the passive element is a capacitor which comprises: a first metal layer formed on the first electric shield line; a second metal layer formed over the first metal layer and below the second electric shield line, and having a portion superimposed with the first metal layer; and a dielectric formed in an area where the first and second metal layers are superimposed.

7. The module of claim 6, wherein the length from the first electric shield line to the first metal layer is almost identical with the length from the second electric shield line to the second metal layer.

8. The module of claim 7, wherein the length from the first electric shield line to the first metal layer is greater than the length from the first metal layer to the second metal layer.

9. The module of claim 6, wherein the substrate has grooves, each with a flat bottom.

10. The module of claim 9, wherein the capacitor is formed on a part corresponding to a groove.

11. The module of claim 10, wherein the second electric shield line and the second metal layer are flat.

12. The module of claim 9, wherein the inductor is formed on a part corresponding to a groove.

13. The module of claim 1, wherein the ICs comprise one or more first ICs for processing RF band signals, and one or more second ICs for processing base band signals.

14. The module of claim 1, wherein the connection line connects the passive elements.

15. The module of claim 1, wherein the electric shield line is one of a ground, a bias voltage supplying line, or a mixed line of the ground and the bias voltage supplying line.
